# FASCICULE DE BREVET EUROPEEN

(11) **EP 2 376 679 B1**
(45) Date de publication et mention de la délivrance du brevet: **27.03.2013**
(21) Numéro de dépôt: 09763974.4
(22) Date de dépôt: 04.12.2009
(51) Int. Cl.: C30B 11/00, C30B 33/02, C30B 35/00

(54) **FOUR DE FUSION-SOLIDIFICATION COMPORTANT UNE MODULATION DES ÉCHANGES THERMIQUES PAR LES PAROIS LATÉRALES**
SCHMELZ-/VERFESTIGIUNGSOFEN MIT VARIABLEM WÄRMEAUSTAUSCH ÜBER DIE SEITENWÄNDE
MELTING/SOLIDIFICATION FURNACE WITH VARIABLE HEAT EXCHANGE VIA THE SIDE WALLS

(30) Priorité: 19.12.2008 FR 0807241
(43) Date de publication de la demande: 19.10.2011
(73) Titulaire: Commissariat à l'Énergie Atomique et aux Énergies Alternatives, 75015 Paris (FR)
(72) Inventeur: PELLETIER, David, F-73000 Chambéry (FR); GARANDET, Jean-Paul, F-73370 Le Bourget du Lac (FR)
(74) Mandataire: Talbot, Alexandre
(86) Numéro de dépôt international: PCT/EP2009/066393
(87) Numéro de publication internationale: WO 2010/069784

(56) Documents cités:
- EP-A- 0 775 766
- JP-A- 5 024 964
- JP-A- 2004 010 461
- US-A1- 2007 227 189

## Description

### Domaine technique de l'invention

L'invention est relative à un four de fusion et de solidification pour matériau cristallin comportant :
- un creuset ayant un fond et des parois latérales,
- un système latéral d'isolation thermique disposé à la périphérie du creuset autour des parois latérales,
- des moyens de déplacement d'au moins un élément latéral du système latéral d'isolation thermique, par rapport aux parois latérales, entre une position d'isolation et une position favorisant les fuites thermiques.

### État de la technique

De manière conventionnelle, les matériaux cristallins, typiquement les matériaux semi-conducteurs et les matériaux métalliques ne peuvent être utilisés tels quels dans les différents domaines technologiques à cause d'une pureté insuffisante et/ou d'une structure cristalline mal adaptée. Afin que les matériaux cristallins soient conformes à un cahier des charges très strict, ils sont soumis à différents cycles de fusion-solidification afin, par exemple, de réduire la teneur en impuretés dans le matériau et/ou imposer une organisation cristalline dans le matériau solide final.

La purification du matériau cristallin peut être réalisée une première fois lors de la phase de fusion, en utilisant un procédé de purification de la phase liquide, par exemple, avec une torche à plasma. La purification peut également être réalisée lors de la solidification car les impuretés ségrégent préférentiellement depuis la phase solide vers le matériau fondu. De manière conventionnelle, la phase de solidification est utilisée pour définir la phase cristalline du matériau cristallin.

De manière classique, le matériau à cristallisé est disposé, sous la forme d'une charge, dans un creuset qui est lui-même disposé dans un four vertical. Le four comporte des moyens de chauffage pour faire fondre le matériau cristallin ainsi que des moyens de refroidissement pour imposer un gradient thermique bien particulier au matériau fondu lors de sa phase de refroidissement. Les moyens de chauffage sont par exemple choisis de type inductif car ils permettent simultanément de chauffer le matériau cristallin tout en réalisant le brassage du matériau fondu.

Cependant, lors des différentes phases du traitement du matériau à cristalliser, les fonctionnalités du four de traitement et de ses éléments constitutifs sont différentes. Tout d'abord, lors de la fusion du matériau, une très bonne isolation du four et surtout du creuset est nécessaire afin de réduire les pertes thermiques et assurer ainsi un rendement suffisant du four.

Dans le cas de la purification, le contrôle de la température du four est important tout comme l'obtention d'un brassage efficace. Il est donc important de maîtriser la quantité d'énergie fournie au creuset, par rapport à celle qui est perdue par le creuset pour contrôler la température du matériau fondu. Par ailleurs, un bon brassage assure un renouvellement de la surface libre en polluants. Comme précisé plus haut, les moyens de chauffage inductif réalisent simultanément le chauffage et le brassage du bain liquide. Plus le courant circulant dans les bobines est important et plus le brassage et le chauffage sont importants, il est alors très difficile de maîtriser de façon précise un contrôle strict de la température du four tout en maintenant un brassage élevé, ces deux conditions étant contradictoires.

Dans le cas de la solidification dirigée, l'extraction de la chaleur du matériau doit être parfaitement contrôlée, car c'est le gradient thermique appliqué au creuset qui conditionne l'avancée du front de solidification et ainsi la qualité cristallographique du matériau final. De plus, lors de la cristallisation, la phase liquide est également brassée pour assurer une répartition homogène des éléments constituants du matériau.

Le document WO 2005/105670 décrit une installation de fabrication de blocs en matériau semi-conducteur. Cette installation comporte deux enceintes distinctes et dédiées à des opérations spécifiques. Une première enceinte et un premier creuset sont utilisés pour réaliser la fusion et la purification du matériau semi-conducteur. Une seconde enceinte et un second creuset sont ensuite utilisés pour réaliser la cristallisation. Cette installation est complexe, elle nécessite des moyens de transvasement du matériau fondu du premier creuset dans le second creuset. Cette installation occupe une surface importante car il faut installer et gérer deux enceintes.

Le document FR 2553232 décrit un dispositif pour élaborer un lingot d'un matériau semi-conducteur polycristallin. Ce dispositif comporte un creuset à l'intérieur duquel est disposé un matériau semi-conducteur. Le dispositif comporte des moyens de chauffage par induction et le creuset est calorifugé au moyen d'un feutre de carbone disposé contre les parois latérales et le fond du creuset. Le dispositif réalise la fusion et la cristallisation du matériau semi-conducteur dans le même creuset. La cristallisation est obtenue en retirant le feutre qui est disposé sous le creuset ce qui crée une fuite thermique par le fond du creuset. Cependant, le gradient thermique perpendiculaire au fond du creuset induit dans le matériau fondu un gradient thermique stabilisant (froid en bas), qui s'oppose aux mouvements de brassage nécessaires à l'obtention d'un matériau homogène.

Le document JP 05024964 décrit un dispositif de cristallisation dans lequel un bouclier isolant se déplace longitudinalement, c'est-à-dire perpendiculairement au fond du creuset. Le document US 2007/0227189 décrit un dispositif de cristallisation dans lequel des éléments plus thermiquement conducteurs se déplacent pour entrer en contact avec la paroi latérale d'un creuset.

### Objet de l'Invention

L'invention a pour objet un four de fusion-cristallisation qui soit facile à mettre en oeuvre, qui n'utilise qu'un seul creuset pour la fusion et la cristallisation et qui permette de contrôler la surchauffe du matériau fondu tout en ayant un brassage important.

Le four selon l'invention est caractérisé par les revendications annexées et plus particulièrement par le fait que :
- le système latéral d'isolation thermique est constitué par au moins deux sous-éléments adjacents formant un anneau continu dans la position d'isolation et discontinu dans la position favorisant les fuites thermiques et en ce qu'il comporte des moyens de déplacement dudit au moins un élément latéral suivant une direction latérale perpendiculaire à une direction longitudinale.

### Description sommaire des dessins

D'autres avantages et caractéristiques ressortiront plus clairement de la description qui va suivre de modes particuliers de réalisation de l'invention donnés à titre d'exemples non limitatifs et représentés par les dessins annexés, dans lesquels :
- la figure 1 représente, de manière schématique, en vue de dessus, un mode de réalisation particulier d'un creuset et d'un élément latéral d'isolation thermique, selon l'invention,
- les figures 2 et 3 représentent, de manière schématique, en section longitudinale, un autre mode de réalisation particulier d'un creuset et d'éléments latéraux d'isolation thermique, selon l'invention, dans deux configurations d'isolation différentes,
- les figures 4 à 6 représentent, de manière schématique, en vue de dessus, un troisième mode de réalisation particulier d'un creuset et d'éléments latéraux d'isolation thermique, selon l'invention, dans différentes configurations d'isolation,

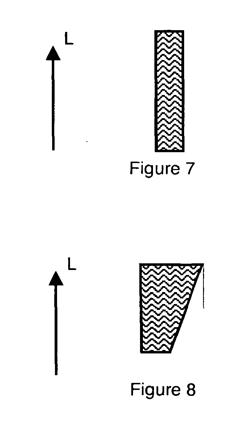

- les figures 7 et 8 représentent, de manière schématique, des sections longitudinales d'un élément latéral d'isolation thermique selon l'invention.

### Description d'un mode préférentiel de l'invention

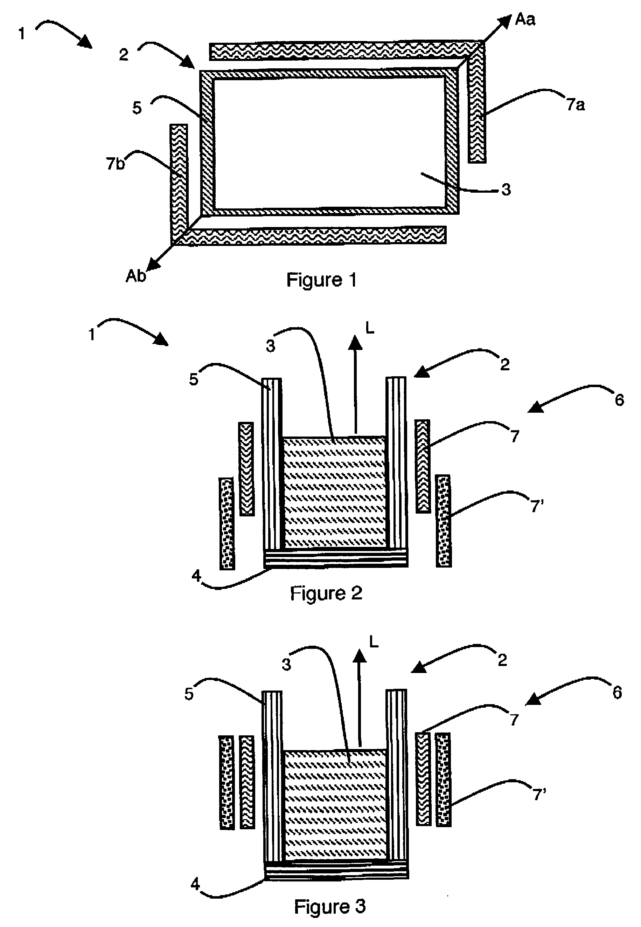

Comme illustré aux figures 1 à 6, le four 1 de fusion-solidification comporte un creuset 2 dans lequel se trouve un matériau cristallin 3 de type semi-conducteur ou métallique. Le four 1 comporte également des moyens de chauffage par induction électromagnétique (non représentées) du matériau cristallin 3. Les moyens de chauffage sont réalisés, par exemple, par une ou plusieurs bobines à l'intérieur desquelles circule un courant alternatif de fréquence prédéfinie.

Le creuset 2 a un fond 4 et des parois latérales 5 en matériau réfractaire non refroidi, le creuset est donc de type creuset chaud. Les parois latérales 5 sont orientées suivant une direction longitudinale L qui est perpendiculaire au fond 4 du creuset 2. Les parois 5 ont une hauteur h depuis le fond 4 du creuset 2 dans la direction longitudinale L. Le creuset 2 présente une surface externe qui correspond à la surface extérieure de ses parois latérales 5. Le creuset 2 est associé à des moyens de modulation des fuites thermiques latérales. Ces moyens de modulation permettent de faire évoluer la proportion d'énergie thermique qui quitte le creuset 2 par ses parois latérales 5. Il y a alors un flux modulable d'énergie qui quitte le creuset en passant au travers de la surface externe du creuset 2.

Pour cela, le four 1 comporte un système latéral d'isolation thermique 6, de forme annulaire, qui est disposé en périphérie du creuset 2 autour des parois latérales 5. Le système latéral d'isolation thermique 6 est mobile par rapport au creuset 2. Avantageusement, au moins les parois latérales 5 du creuset 2 sont recouvertes par un matériau isolant supplémentaire (non représenté) qui est fixe par rapport au creuset 2 et qui réalise une première isolation thermique du creuset 2. Le système latéral d'isolation thermique 6 comporte au moins un élément latéral d'isolation thermique 7 qui se déplace par rapport au creuset 2.

Dans une variante de réalisation, le système latéral d'isolation thermique 6 comporte un élément latéral d'isolation thermique principal 7 et un élément latéral d'isolation thermique additionnel 7' (figures 2 à 6). L'élément latéral d'isolation thermique principal 7 est alors entouré par l'élément latéral d'isolation thermique additionnel 7' distinct. Ces deux éléments latéraux d'isolation thermique 7 et 7' sont mobiles et peuvent se déplacer indépendamment l'un de l'autre.

Si le système latéral d'isolation thermique 6 ne comporte qu'un seul élément latéral d'isolation thermique, l'élément latéral d'isolation thermique 7, ce dernier peut être assimilé au système 6 et il peut être noté comme l'élément latéral d'isolation thermique 6.

Les moyens de modulation des fuites thermiques latérales comportent des moyens de déplacement du système latéral d'isolation thermique 6 par rapport aux parois latérales du creuset 2. Les moyens de déplacement peuvent également comporter, suivant les modes de réalisation, des moyens de déplacement indépendant des éléments latéraux d'isolation thermique principal 7 et additionnel 7'. Le système latéral d'isolation thermique 6 se déplace alors entre une position d'isolation et une position qui favorise les fuites thermiques par les parois latérales 5.

Les moyens de déplacement peuvent comporter des moyens de déplacement d'au moins un élément latéral d'isolation thermique 7, 7' suivant la direction longitudinale L. Ce mode de réalisation est avantageux si l'élément latéral d'isolation thermique 7, 7' a une hauteur égale à celle du creuset 2. Avantageusement, dans la position d'isolation, toute la hauteur de l'élément latéral d'isolation thermique 7, 7' est en regard des parois latérales afin de réduire au maximum les pertes.

Comme illustré aux figures 2 et 3, les moyens de modulation comportent des moyens de déplacement des éléments latéraux d'isolation thermique principal 7 et additionnel 7' suivant la direction longitudinale L. Dans ce cas de figure, les éléments latéraux d'isolation 7 et 7' se déplacent par rapport au fond 4 du creuset 2 et leur écartement par rapport aux parois latérales 5 est constant.

Ce mode de réalisation est avantageux si les éléments latéraux d'isolation 7 et 7' ont une hauteur inférieure à celle du creuset 2 et particulièrement inférieure à celle de la quantité de matière fondue dans le creuset 2. Dans une position d'isolation dite verticale, les éléments latéraux d'isolation 7 et 7' recouvrent la totalité de la hauteur des parois latérales 5 tout en ayant, entre eux, le maximum de surface en regard. Afin d'augmenter les pertes thermiques par les parois latérales 5, la couverture de l'intégralité de la hauteur des parois latérales 5 n'est plus assurée. Les éléments latéraux d'isolation 7 et 7' se rapprochent l'un de l'autre par un déplacement longitudinal. C'est l'élément latéral d'isolation 7 ou 7' qui recouvre la partie inférieure des parois latérales 5 qui se déplace longitudinalement vers la partie supérieure des parois latérales 5.

Dans un autre mode de réalisation qui peut être combiné au précédent, les moyens de déplacement peuvent également comporter des moyens de déplacement de l'élément latéral d'isolation thermique 6 suivant une direction latérale. La direction latérale de déplacement est perpendiculaire à la direction longitudinale L. Dans ce cas de figure, le système latéral d'isolation thermique 6 comporte au moins un l'élément latéral d'isolation thermique qui est divisé obligatoirement en une pluralité de sous-éléments afin d'autoriser le rapprochement ou l'écartement de chacun des sous-éléments dans une direction qui lui est propre. En d'autres termes, les moyens de modulation des fuites thermiques latérales comportent des moyens de déplacement de chaque sous-élément indépendamment les uns des autres.

Le système latéral d'isolation thermique 6 est alors constitué par au moins deux sous-éléments 7a, 7b (figure 1). L'élément latéral d'isolation thermique est découpé suivant au moins un premier plan de coupe sécant au fond du creuset 2.

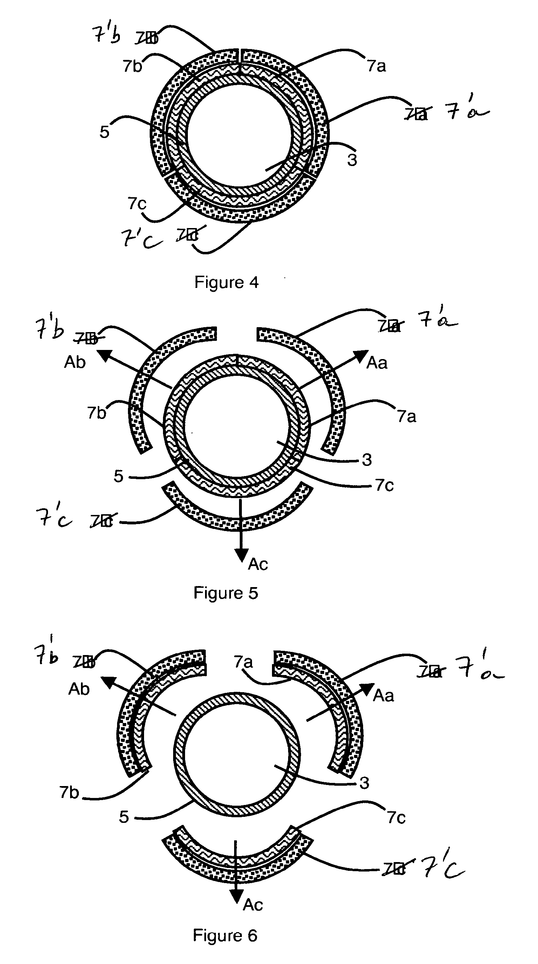

Comme illustré aux figures 4 à 6, l'élément latéral d'isolation thermique principal 7 est constitué par trois sous-éléments 7a, 7b et 7c qui forment un anneau qui entoure le creuset 2. Cet anneau est continu lorsque l'élément latéral d'isolation thermique est dans une position d'isolation, c'est-à-dire que tous les sous-éléments sont jointifs. Dans une position favorisant les fuites thermiques, les sous-éléments ne sont plus jointifs et l'anneau est discontinu.

Il en va de même du système latéral d'isolation thermique 6 qui entoure le creuset rectangulaire de la figure 1.

De manière analogue, l'élément latéral d'isolation thermique additionnel 7' est constitué par trois sous-éléments 7'a, 7'b, 7'c sur les figures 4 à 6. Les éléments latéraux d'isolation thermique 7 et 7' peuvent être découpés suivant des plans de coupe différents sécants au fond du creuset 2.

Chaque sous-élément 7a, 7b, 7c, 7'a, 7b, 7'c comporte deux surfaces principales et quatre surfaces secondaires. La surface principale disposée en regard de la surface externe de la paroi latérale du creuset est appelée surface interne du sous-élément La surface principale dirigée vers l'extérieur est appelée surface externe du sous-élément. La surface interne d'un sous-élément est complémentaire de la surface externe du sous-élément ou du creuset en regard. Ainsi, à titre d'exemple, la surface interne des sous-éléments 7a est sensiblement complémentaire de la surface externe en regard du creuset, de sorte qu'elles peuvent s'emboîter l'une sur l'autre. Les éléments latéraux d'isolation thermique 6 et 7 peuvent donc entourer les parois latérales 5 du creuset 2 afin d'avoir une isolation thermique maximale.

De la même manière, les surfaces internes et externes en regard des éléments latéraux d'isolation thermique principal 7 et additionnel 7' sont complémentaires de sorte qu'elles peuvent s'emboîter l'une sur l'autre. L'élément latéral d'isolation thermique additionnel 7' peut donc entourer les parois latérales de l'élément latéral d'isolation thermique principal 7 afin d'avoir une isolation thermique maximale dans sa position d'isolation.

Comme illustré aux figures 3 à 6, les moyens de modulation peuvent comporter des moyens de déplacement des éléments latéraux d'isolation 7 et 7' suivant des directions latérales A. Chaque élément latéral d'isolation 7 et 7' étant composé par une pluralité de sous-éléments, ces sous-éléments se déplacent suivant une direction latérale, qui leur est propre et prédéfinie, Aa, Ab, Ac sur la figure 4. Cette direction latérale de déplacement peut alors être radiale ou tangentielle. Ainsi, il est envisageable d'avoir un déplacement tangentiel par rapport aux surfaces latérales, c'est-à-dire un déplacement selon une tangente à un rayon d'un creuset cylindrique ou parallèlement à une face latérale d'un creuset à base carrée ou rectangulaire. Il est également envisageable d'avoir un déplacement radial

Cette direction latérale de déplacement est perpendiculaire à la direction longitudinale L du creuset 2 et passe par un point caractéristique de chaque isolant élémentaire (7a-7c, 7'a-7'c). La direction latérale de déplacement A peut être un vecteur orthogonal à la surface interne plane du sous-élément. Dans le cas du parallélépipède, la direction latérale de déplacement peut être encore la direction qui assure l'obtention d'un écartement identique entre les différences faces du sous-élément et les parois latérales en regard du creuset 2.

Les plans de coupe des éléments latéraux d'isolation thermique 7 et 7' sont avantageusement identiques, mais ils peuvent également être décalés. Il est également envisageable que les éléments latéraux d'isolation thermique 7 et 7' n'aient pas le même nombre de sous-éléments. Les éléments latéraux d'isolation 7 et 7' pouvant être divisés selon des plans de coupe différents, un sous-élément de l'élément latéral d'isolation thermique principal 7 peut recouvrir par exemple, deux sous-éléments de l'élément latéral d'isolation thermique additionnel 7'. Ils ne sont donc pas obligés de posséder les mêmes directions de déplacement, contrairement au cas particulier illustré aux figures 4 à 6.

Dans un mode de réalisation particulier combinable avec les précédents, la surface interne du système latéral d'isolation thermique 6 ou de l'élément latéral d'isolation thermique principal 7 est légèrement plus grande que la surface externe du creuset 2 de sorte que dans une position d'isolation, une fine pellicule d'air ou de gaz prédéterminé est présente entre le creuset 2 et l'élément latéral d'isolation 6 ou 7, donc entre le creuset 2 et chacun des sous-éléments. Il peut en être de même entre les éléments latéraux d'isolation thermique principal 7 et additionnel 7' afin que dans une position d'isolation, une fine pellicule d'air ou de gaz prédéterminé soit présente entre ces deux éléments 7 et 7'.

Si, le creuset 2 est de forme cylindrique, les sous-éléments 7, 7' du système latéral d'isolation thermique 6 ont avantageusement la forme d'un arc de cercle d'une épaisseur prédéfinie. Si le creuset 2 est à base carrée ou à base rectangulaire, la surface interne des sous-éléments peut être une surface plane. Cependant, si le sous-élément est en regard d'une arrête du creuset 2, sa surface interne est dite complexe et comporte un angle entre deux surfaces planes (figure 1).

Afin d'être utilisable lors d'une phase de fusion, de purification et de solidification, le système latéral d'isolation thermique 6 se déplace entre une position d'isolation et une position favorisant les fuites thermiques par les parois latérales 5. Typiquement, le système latéral d'isolation thermique 6 se rapproche ou s'éloigne des parois latérales 5 ou du fond 4 du creuset 2.

Comme illustré aux figures 3 à 6, dans sa position d'isolation, la distance entre le creuset 2 et le système latéral d'isolation thermique 6 est la plus faible autorisée, ce qui se traduit par une distance minimale des éléments latéraux principal 7 et additionnel 7' par rapport au parois latérales 5. Cette distance minimale peut être nulle ou égale à une épaisseur prédéterminée. Dans sa position favorisant les fuites thermiques, la distance entre le creuset 2 et le système latéral d'isolation thermique 6 est la plus grande autorisée et les fuites thermiques par les parois latérales 5 sont les plus importantes.

De cette manière, selon la configuration prise par les moyens de modulation, les fuites thermiques par les parois latérales du creuset peuvent être très réduites ou alors plus importantes, la proportion de fuite par les parois latérales pouvant évoluée de façon continue ou discontinue.

Lors de la phase de fusion, les fuites sont réduites au minimum ce qui permet d'avoir simultanément un chauffage et un brassage efficaces avec les moyens de chauffage par induction tout en conservant un bon rendement énergétique de cette opération. Lors de la cristallisation, les fuites thermiques par les parois latérales sont plus importantes et elles peuvent augmenter de manière continue ou de manière discrète au fur et à mesure de la cristallisation pour s'adapter à une modification de la conductance thermique du matériau dans le creuset.

Dans ce mode de réalisation, il est avantageux que les moyens de modulation comportent des moyens de déplacement du système latéral d'isolation 6, par exemple des éléments latéraux d'isolation 7 et 7', en rotation autour de l'axe longitudinal du creuset 2. En réalisant la rotation du système latérale 6 ou des éléments 7 et 7' indépendamment l'un de l'autre, on évite de former des zones froides sur le creuset qui sont particulièrement préjudiciables. Les éléments 7 et 7' peuvent se déplacer indépendamment l'un de l'autre, l'un des deux peut donc être fixe par rapport à l'autre ou ils peuvent se mouvoir à des vitesses différentes ou dans des sens opposés.

La position longitudinale de l'élément latéral d'isolation thermique 6 par rapport au fond 4 du creuset 2 permet de créer un gradient thermique axial plus ou moins important sur la hauteur du creuset 2.

Dans un autre mode de réalisation particulier qui correspond à la combinaison des différents modes de réalisation des figures 1 à 6, le système latéral d'isolation thermique 6 peut être mobile suivant une direction longitudinale et suivant une direction latérale. Ce mode de réalisation peut évidemment être appliqué aux éléments latéraux d'isolation thermique principal 7 et additionnel 7'. Les éléments latéraux d'isolation 7 et 7' peuvent donc se déplacer tous les deux dans les directions longitudinale et latérales. Il est également envisageable que l'élément latéral d'isolation thermique principal 7 se déplace suivant une direction longitudinale et que l'élément latéral d'isolation thermique additionnel 7' se déplace suivant une direction latérale.

Le matériau isolant constituant le système latéral d'isolation thermique 6 est avantageusement réalisé à partir d'un matériau électriquement isolant de manière à limiter le plus possible le couplage électromagnétique engendré par les moyens de chauffage du four. Le matériau isolant présente une conductivité électrique inférieure à 1 S/m. Le matériau isolant est également choisi parmi les matériaux présentant une conductivité thermique faible, typiquement inférieure à 15W/m/K.

Le matériau isolant du système latéral d'isolation thermique 6 peut être choisi, par exemple, parmi l'alumine, le Macor^{™}, la mullite ou la zircone. Avantageusement, tous les éléments et sous-éléments latéraux d'isolation thermique sont réalisés dans le même matériau.

Avantageusement, le matériau isolant présente un coefficient d'émissivité compris entre 0,3 et 0,6. En effet, si l'émissivité est faible, le caractère isolant thermique de l'isolant thermique latéral et de l'isolant thermique latéral additionnel est renforcé, mais l'inertie du four augmente.

Le four peut fonctionner sous vide ou sous une atmosphère gazeuse contrôlée. Cette atmosphère gazeuse peut être réalisée par un gaz choisi parmi l'argon, l'oxygène, l'hydrogène, l'hélium, l'azote ou l'air ou un mélange à base de ces gaz. Avantageusement, l'atmosphère est constituée par un gaz neutre ou un mélange de gaz neutres.

Les pertes thermiques par les parois latérales 5 sont réalisées par rayonnement et par convection si le four 1 comporte une atmosphère gazeuse.

Suivant la direction longitudinale, l'épaisseur du système latéral d'isolation thermique 6 et/ou des éléments 7 et 7' est constante ou peut présenter une évolution continue. La section de l'élément latéral d'isolation thermique 7 et 7' dans un plan de coupe perpendiculaire au fond du creuset a la forme d'un rectangle ou d'un trapèze rectangle. Si l'épaisseur n'est pas constante sur toute la hauteur de l'élément latéral d'isolation 6, 7, 7', l'épaisseur la plus importante se situe avantageusement dans la partie supérieure de l'isolant thermique. Cette variation d'épaisseur permet également de créer un gradient thermique axial plus ou moins important sur la hauteur du creuset 2.

Dans un mode de réalisation particulier, l'isolant thermique latéral et/ou de l'isolant thermique latéral additionnel est percé par une pluralité de trous afin de moduler la fuite thermique. Il peut être alors avantageux de contrôler la rotation ou l'angle de décalage entre les élément latéraux d'isolation 7 et 7' afin de venir obstruer complètement/partiellement les trous de l'élément thermique latéral principal 7 par l'élément thermique latéral additionnel 7'. Ce mode de fonctionnement est particulièrement avantageux dans le cas d'un creuset cylindrique.

Dans ce mode de réalisation, les moyens de modulation peuvent comporter des moyens de déplacement du système latéral d'isolation 6, par exemple des éléments latéraux d'isolation 7 et 7', en rotation autour de l'axe longitudinal du creuset 2.

Avantageusement, l'épaisseur du système latéral d'isolation thermique 6 ou la somme des épaisseurs des éléments 7 et 7' est comprise entre 2 et 20mm, encore plus avantageusement entre 5 et 10mm. Typiquement, la hauteur de le système latéral d'isolation thermique 6 est comprise entre 10 et 20 cm.

A titre d'exemple, le déplacement suivant la direction latérale entre le système latéral d'isolation thermique 6 et le creuset peut être comprise entre 0 et 10cm.

A titre d'exemple également, le déplacement longitudinal du système latéral d'isolation thermique 6 est compris entre 5 et 15cm.

Le flux de chaleur extrait du creuset 2 est modulé par la variation de la configuration géométrique du creuset 2 par rapport à l'élément latéral d'isolation thermique 6 et éventuellement aux éléments 7 et 7'. La modulation du flux thermique peut être réalisée en modulant uniquement ou en combinaison :
- l'écartement, dans une direction latérale, entre le système latéral d'isolation thermique 6 et les parois latérales 5,
- l'écartement, dans une direction latérale, entre l'élément latéral d'isolation thermique principal 7 et l'élément latéral d'isolation thermique additionnel 7 ainsi que leur écartement par rapport au creuset,
- le recouvrement, dans une direction verticale, de l'élément latéral d'isolation thermique 6, ou des éléments 7 et 7', avec les parois latérales 5 du creuset 2,
- le recouvrement, dans une direction verticale, des éléments 7 et 7' entre eux,
- la composition de l'atmosphère gazeuse au sein du four 1,
- le recouvrement par rotation angulaire.

A titre d'exemple, un four de cristallogenèse selon l'invention est un four adapté au silicium qui peut être réalisé de la manière qui suit. Les moyens de modulation des pertes thermiques latérales comportent un élément latéral d'isolation thermique principal et un élément latéral d'isolation thermique additionnel. Ces deux éléments latéraux d'isolation thermique sont réalisés en alumine. Le creuset est de type cylindrique, comme celui de la figure 3. Le diamètre du creuset est égal à 20cm et les parois latérales ont une hauteur égale à 25cm. Les éléments latéraux d'isolation thermique ont une hauteur égale à 15cm et une épaisseur égale à 8mm. Le four comporte également un matériau isolant fixe dont l'épaisseur est égale à 5 cm. En fonctionnement, la température de la face interne de l'isolant est de l'ordre de 800°C.

Pendant la phase de fusion, les éléments latéraux d'isolation thermique sont dans une position d'isolation. Ils sont jointifs du creuset afin de réduire au maximum les pertes thermiques depuis les parois latérales du creuset. Cette position d'isolation est illustrée à la figure 2 ou 4. Le flux de chaleur extrait du creuset par les parois latérales est alors de l'ordre de 10kW. Une fois que la solidification est initiée, l'élément latéral d'isolation thermique additionnel se déplace longitudinalement de manière continue suivant une vitesse qui est reliée à la vitesse de solidification du silicium depuis le fond du creuset. La direction de solidification du silicium est identique à la direction de déplacement de l'élément latéral d'isolation thermique additionnel. La vitesse de solidification est de l'ordre de 10mm/h.

A la fin de la solidification, lorsqu'il ne reste presque plus de matériau fondu, l'élément latéral d'isolation thermique additionnel s'est déplacé longitudinalement de 10cm et cette configuration est illustrée à la figure 3 ou 6. Le flux de chaleur extrait par les parois latérales est de l'ordre de 13kW, ce qui représente une augmentation de 30% du flux extrait par rapport à la configuration d'isolation.

Dans le cas où les deux éléments latéraux d'isolation thermique ne sont plus réalisés en alumine mais en Macor^{™}, l'augmentation du flux extrait par rapport à la configuration d'isolation est de l'ordre de 75%.

Le four comporte des moyens de refroidissement qui sont disposés sous le fond du creuset afin d'imposer un gradient thermique vertical.

## Revendications

1. Four (1) de fusion et de solidification pour matériau cristallin (3) comportant :
- un creuset (2) ayant un fond (4) et des parois latérales (5), le creuset présentant une direction longitudinale perpendiculaire au fond (4)
- un système latéral d'isolation thermique (6) disposé autour du creuset (2) face aux parois latérales (5), le système latéral d'isolation thermique (6) comportant au moins un élément latéral (7a, 7b, 7c, 7'a, 7'b, 7'c) se déplaçant entre une position d'isolation et une position favorisant les fuites thermiques,
four **caractérisé en ce que** :
- le système latéral d'isolation thermique (6) est constitué par au moins deux sous-éléments adjacents formant un anneau continu dans la position d'isolation et discontinu dans la position favorisant les fuites thermiques et **en ce qu'**il comporte des moyens de déplacement dudit au moins un élément latéral (7a, 7b, 7c, 7'a, 7'b, 7'c) suivant une direction latérale perpendiculaire à la direction longitudinale.

2. Four selon la revendication 1, **caractérisé en ce que** le système latéral d'isolation thermique (6) comporte au moins des éléments latéraux d'isolation principal (7a, 7b, 7c) et additionnel (7'a, 7'b, 7'c).

3. Four selon l'une des revendications 1 et 2, **caractérisé en ce que** les moyens de déplacement comportent des moyens de déplacement d'au moins un élément latéral (7a, 7b, 7c, 7'a, 7'b, 7'c) du système latéral d'isolation thermique (6), suivant une direction longitudinale.

4. Four selon l'une quelconque des revendications 1 à 3, **caractérisé en ce que** les moyens de déplacement comportant des moyens de déplacement d'au moins un élément latéral (7a, 7b, 7c, 7'a, 7'b, 7'c) du système latéral d'isolation thermique (6) en rotation par rapport à l'axe longitudinal du creuset (2).

5. Four selon l'une quelconque des revendications 1 à 4, **caractérisé en ce qu'**au moins un élément latéral d'isolation thermique (7a, 7b, 7c, 7'a, 7'b, 7'c) présente une émissivité comprise entre 0,3 et 0,6.

6. Four selon l'une quelconque des revendications 1 à 5, **caractérisé en ce que** le système latéral d'isolation thermique (6) est réalisé dans un matériau choisi parmi l'alumine, le Macor^{™}, la mullite ou la zircone.

7. Four selon l'une quelconque des revendications 1 à 6, **caractérisé en ce que** le système latéral d'isolation thermique (6) a une hauteur identique à une hauteur des parois latérales (5).

8. Four selon l'une quelconque des revendications 1 à 6, **caractérisé en ce que** le système latéral d'isolation thermique (6) a une hauteur inférieure à une hauteur des parois latérales (5).

9. Four selon l'une quelconque des revendications 1 à 8, **caractérisé en ce qu'**au moins un élément latéral (7a, 7b, 7c, 7'a, 7'b, 7'c) du système latéral d'isolation thermique (6) a une section rectangulaire selon un plan perpendiculaire au fond (4) du creuset (2).

10. Four selon l'une quelconque des revendications 1 à 8, **caractérisé en ce qu'**au moins un élément latéral (7a, 7b, 7c, 7'a, 7'b, 7'c) du système latéral d'isolation thermique (6) a une section trapézoïdale rectangle selon un plan perpendiculaire au fond (4) du creuset (2).

11. Four selon l'une quelconque des revendications 1 à 10, **caractérisé en ce qu'**il comporte des moyens de chauffage du matériau cristalline par induction électromagnétique et **en ce que** le système latéral d'isolation thermique (6) a une conductivité électrique inférieure à 1S/m et une conductivité thermique inférieure à 15W/m/K.

## Claims

1. A melting and solidification furnace (1) for crystalline material (3) comprising:
- a crucible (2) having a bottom (4) and side walls (5), the crucible presenting a longitudinal direction perpendicular to the bottom (4)
- lateral thermal insulation system (6) arranged around the crucible (2) facing the side walls (5), the lateral thermal insulation system (6) comprising at least one lateral element (7a, 7b, 7c, 7'a, 7'b, 7'c) moving between an insulating position and a position fostering thermal leakage
furnace **characterized in that**:
- the lateral thermal insulation system (6) is formed by at least two adjacent sub-elements forming a ring that is continuous in the insulating position and discontinuous in the position fostering thermal leakage,
and **in that** it comprises moving means of said at least one lateral element (7a, 7b, 7c, 7'a, 7'b, 7'c) in a lateral direction perpendicular to the longitudinal direction.

2. The furnace according to claim 1, **characterized in that** the lateral thermal insulation system (6) comprises at least main lateral insulation elements (7a, 7b, 7c) and additional lateral insulation elements (7'a, 7'b, 7'c).

3. The furnace according to one of claims 1 and 2, **characterized in that** the moving means comprise moving means of at least one lateral element (7a, 7b, 7c, 7'a, 7'b, 7'c) of the lateral thermal insulation system (6) in a longitudinal direction.

4. The furnace according to any one of claims 1 to 3, **characterized in that** the moving means comprise moving means of at least one lateral element (7a, 7b, 7c, 7'a, 7'b, 7'c) of the lateral thermal insulation system (6) in rotation with respect to the longitudinal axis of the crucible (2).

5. The furnace according to any one of claims 1 to 4, **characterized in that** at least a lateral thermal insulation element (7a, 7b, 7c, 7'a, 7'b, 7'c) presents an emissivity comprised between 0.3 and 0.6.

6. The furnace according to any one of claims 1 to 5, **characterized in that** the lateral thermal insulation system (6) is made from a material chosen from alumina, Macor^{™}, mullite or zircon.

7. The furnace according to any one of claims 1 to 6, **characterized in that** the lateral thermal insulation system (6) has an identical height to a height of the side walls (5).

8. The furnace according to any one of claims 1 to 6, **characterized in that** the lateral thermal insulation system (6) has a smaller height than a height of the side walls (5).

9. The furnace according to any one of claims 1 to 8, **characterized in that** at least one lateral element (7a, 7b, 7c, 7'a, 7'b, 7'c) of the lateral thermal insulation system (6) has a rectangular cross-section in a plane perpendicular to the bottom (4) of the crucible (2).

10. The furnace according to any one of claims 1 to 8, **characterized in that** at least one lateral element (7a, 7b, 7c, 7'a, 7'b, 7'c) of the lateral thermal insulation system (6) has a rectangular trapezoidal cross-section in a plane perpendicular to the bottom (4) of the crucible (2)

11. The furnace according to any one of claims 1 to 10, **characterized in that** it comprises means for heating the crystalline material by electromagnetic induction and **in that** the lateral thermal insulation system (6) has an electric conductivity of less than 1S/m and a thermal conductivity of less than 15W/m/K.

## Patentansprüche

1. Schmelz- und Verfestigungsofen (1) für kristallines Material (3), umfassend:
- ein Gestell (2) mit einem Boden (4) und Seitenwänden (5), wobei das Gestell eine zu dem Boden (4) senkrechte Längsrichtung aufweist,
- ein seitliches System zur Wärmeisolierung (6), das um das Gestell (2) herum gegenüber den Seitenwänden (5) angeordnet ist, wobei das seitliche Wärmeisolierungssystem (6) wenigstens ein seitliches Element (7a, 7b, 7c, 7'a, 7'b, 7'c) umfasst, das sich zwischen einer Isolierstellung und einer die Wärmeverluste begünstigenden Stellung bewegt,
Ofen, der **dadurch gekennzeichnet ist, dass**:
- das seitliche Wärmeisolierungssystem (6) durch wenigstens zwei benachbarte Unterelemente gebildet ist, die einen in der Isolierstellung durchgehenden und in der die Wärmeverluste begünstigenden Stellung unterbrochenen Ring bilden, und dass es Mittel zum Bewegen des wenigstens einen seitlichen Elements (7a, 7b, 7c, 7'a, 7'b, 7'c) in einer zu der Längsrichtung senkrechten seitlichen Richtung umfasst.

2. Ofen nach Anspruch 1, **dadurch gekennzeichnet, dass** das seitliche Wärmeisolierungssystem (6) wenigstens seitliche Haupt- (7a, 7b, 7c) und Nebenisolierungselemente (7'a, 7'b, 7'c) umfasst.

3. Ofen nach einem der Ansprüche 1 und 2, **dadurch gekennzeichnet, dass** die Bewegungsmittel Mittel zum Bewegen wenigstens eines seitlichen Elements (7a, 7b, 7c, 7'a, 7'b, 7'c) des seitlichen Wärmeisolierungssystems (6) in einer Längsrichtung umfassen.

4. Ofen nach einem der Ansprüche 1 bis 3, **dadurch gekennzeichnet, dass** die Bewegungsmittel Mittel zum Drehbewegen wenigstens eines seitlichen Elements (7a, 7b, 7c, 7'a, 7'b, 7'c) des seitlichen Wärmeisolierungssystems (6) um die Längsachse des Gestells (2) umfassen.

5. Ofen nach einem der Ansprüche 1 bis 4, **dadurch gekennzeichnet, dass** wenigstens ein seitliches Wärmeisolierungselement (7a, 7b, 7c, 7'a, 7'b, 7'c) eine Emissivität zwischen 0,3 und 0,6 aufweist.

6. Ofen nach einem der Ansprüche 1 bis 5, **dadurch gekennzeichnet, dass** das seitliche Wärmeisolierungssystem (6) aus einem Material ausgebildet ist, das aus Aluminiumoxid, Macor^{™}, Mullit oder Zirkonoxid ausgewählt ist.

7. Ofen nach einem der Ansprüche 1 bis 6, **dadurch gekennzeichnet, dass** das seitliche Wärmeisolierungssystem (6) eine mit einer Höhe der Seitenwände (5) identische Höhe aufweist.

8. Ofen nach einem der Ansprüche 1 bis 6, **dadurch gekennzeichnet, dass** das seitliche Wärmeisolierungssystem (6) eine Höhe aufweist, die geringer als eine Höhle der Seitenwände (5) ist.

9. Ofen nach einem der Anspruche 1 bis 8, **dadurch gekennzeichnet, dass** wenigstens ein seitliches Element (7a, 7b, 7c, 7'a, 7'b, 7c) des seitlichen Warmeisolierungssystems (6) in einer zu dem Boden (4) des Gestells (2) senkrechten Ebene einen rechteckigen Querschnitt aufweist.

10. Ofen nach einem der Ansprüche 1 bis 8, **dadurch gekennzeichnet, dass** wenigstens ein seitliches Element (7a, 7b, 7c, 7'a, 7'b, 7'c) des seitlichen Wärmeisolierungssystems (6) in einer zu dem Boden (4) des Gestells (2) senkrechten Ebene einen Querschnitt mit der Form eines rechtwinkligen Trapezes aufweist.

11. Ofen nach einem der Ansprüche 1 bis 10, **dadurch gekennzeichnet, dass** er Mittel zum erhitzen des kristallinen Materials mittels elektromagnetischer Induktion umfasst und dass das seitliche Wärmeisolierungssystem (6) eine elektrische Leitfähigkeit von unter 1S/m sowie eine Wärmeleitfähigkeit von unter 15 W/m/K aufweist.
